# EUROPEAN PATENT SPECIFICATION

(11) **EP 2 092 571 B1**
(45) Date of publication and mention of the grant of the patent: **26.09.2012**
(21) Application number: 07852888.2
(22) Date of filing: 23.10.2007
(51) Int. Cl.: H01L 31/0224

(54) **FRONT ELECTRODE WITH THIN METAL FILM LAYER AND HIGH WORK-FUNCTION BUFFER LAYER FOR USE IN PHOTOVOLTAIC DEVICE AND METHOD OF MAKING SAME**
FRONTELEKTRODE MIT EINER DÜNNEN METALLFILMSCHICHT UND EINER PUFFERSCHICHT MIT HOHER ARBEITSFUNKTION ZUR VERWENDUNG IN EINER FOTOVOLTAGEN ANORDNUNG UND HERSTELLUNGSVERFAHREN DAFÜR
ÉLECTRODE AVANT À COUCHE PELLICULAIRE MÉTALLIQUE MINCE ET COUCHE TAMPON HAUTEMENT FONCTIONNELLE UTILISÉE DANS UN DISPOSITIF PHOTOVOLTAÏQUE ET SON PROCÉDÉ DE RÉALISATION

(30) Priority: 02.11.2006 US 591676
(43) Date of publication of application: 26.08.2009
(73) Proprietor: Guardian Industries Corp., Auburn Hills, MI 48326-1714 (US)
(72) Inventor: KRASNOV, Alexey, Canton, MI 48187 (US)
(74) Representative: Hess, Peter K. G.
(86) International application number: PCT/US2007/022427
(87) International publication number: WO 2008/057202

(56) References cited:
- EP-A- 1 300 889
- US-A1- 2003 218 153
- US-B2- 6 344 608
- BOOTH H J: "Recent applications of pulsed lasers in advanced materials processing" PREPARATION AND CHARACTERIZATION, ELSEVIER SEQUOIA, NL, vol. 453-454, 1 April 2004 (2004-04-01), pages 450-457, XP004495270 ISSN: 0040-6090

## Description

This invention relates to a photovoltaic device including a front electrode/contact. In certain example embodiments, the front electrode of the photovoltaic device includes a highly conductive metal film and a thin high work-function buffer layer. The high-work function buffer layer is located between the metal film and the uppermost semiconductor layer of the photovoltaic device so as to provide for substantial work-function matching between the metal film and the high work-function uppermost semiconductor layer of the device in order to reduce a potential barrier for holes extracted from the device by the front electrode/contact. Optionally, a layer such as a transparent conductive oxide (TCO) or a dielectric may be provided between a front glass substrate and the metal film in certain example instances.

### BACKGROUND AND SUMMARY OF EXAMPLE EMBODIMENTS OF

### INVENTION

Photovoltaic devices are known in the art (e.g., see U.S. Patent Nos. 6,784,361, 6,288,325, 6,613,603, and 6,123,824. Amorphous silicon photovoltaic devices, for example, include a front electrode or contact. Typically, the transparent front electrode (which may include the front contact as used herein) is made of a transparent conductive oxide (TCO) such as zinc oxide or tin oxide formed on a substrate such as a glass substrate. In many instances, the transparent front electrode is formed of a single layer using a method of chemical pyrolysis where precursors are sprayed onto the glass substrate at approximately 400 to 600 degrees C. Front electrodes made solely of an F-doped tin oxide TCO layer are undesirable in that they tend to suffer from darkening in hydrogen atmospheres which may be used during a-Si:H absorber deposition. As another example, front electrodes made solely of a zinc oxide TCO layer are problematic in that they have insufficient conductivity in certain instances.

The EP 1 300 889 A2 discloses a photovoltaic element and photovoltaic device. The herein described element and device comprise an ITO (Indium Tin Oxide) film as a transparent conductive film formed on a semiconductor or a microcrystalline semiconductor, a comb-like collecting electrode formed on the ITO and a cover glass containing alkaline ions is placed on the ITO film and collection electrode with a resin film made of EVA (Ethylene Vinyl Acetate) between them.

Typical TCOs used for certain front electrodes of photovoltaic devices are n-type and therefore can create a Schottky barrier at the interface between the TCO and the uppermost semiconductor layer of the photovoltaic device (e.g., p-type silicon based layer) in a reverse direction to the built-in field. This barrier can act as a barrier for holes extracted from the device by the front electrode, thereby leading to inefficient perfomance.

Thus, it will be appreciated that there exists a need in the art for an improved front electrode for a photovoltaic device which can reduce the potential barrier for holes extracted from the photovoltaic device by the front electrode.

In order to overcome the aforesaid problem, the present invention discloses a photovoltaic device as recited in claim 1 and an electrode adapted to a photovoltaic device as recited in claim 8. Further advantageous embodiments are recited in the dependent claims.

### BRIEF DESCRIPTION OF THE DRAWINGS

FIGURE 1 is a cross sectional view of an example photovoltaic device according to an example embodiment of this invention.

FIGURE 2 is a cross sectional view of an example photovoltaic device according to an example embodiment of this invention.

FIGURE 3 is a graph illustrating band and Fermi level positions of certain materials and a p-type a-Si:H with respect to a vacuum level and a normal hydrogen electrode (NHE).

FIGURE 4(a)-4(b) are graphs illustrating the relative positions of separated TCO layers and a-Si layers for illustrating the advantage of using ITO over ZnAlOx as a buffer layer material, although both may be used in different example embodiments of this invention.

### DETAILED DESCRIPTION OF EXAMPLE EMBODIMENTS OF THE INVENTION

Referring now more particularly to the drawings in which like reference numerals indicate like parts throughout the several views.

Photovoltaic devices such as solar cells convert solar radiation and other light into usable electrical energy. The energy conversion occurs typically as the result of the photovoltaic effect. Solar radiation (e.g., sunlight) impinging on a photovoltaic device and absorbed by an active region of semiconductor material (e.g., a semiconductor film including one or more semiconductor layers such as a-Si layers) generates electron-hole pairs in the active region. The electrons and holes may be separated by an electric field of a junction in the photovoltaic device. The separation of the electrons and holes by the junction results in the generation of an electric current and voltage. In certain example embodiments, the electrons flow toward the region of the semiconductor material having n-type conductivity, and holes flow toward the region of the semiconductor having p-type conductivity. Current can flow through an external circuit connecting the n-type region to the p-type region as light continues to generate electron-hole pairs in the photovoltaic device.

In certain example embodiments, single junction amorphous silicon (a-Si) photovoltaic devices include three semiconductor layers. In particular, a p-layer, an n-layer and an i-layer which is intrinsic. The amorphous silicon film (which may include one or more layers such as p, n and i type layers) may be of hydrogenated amorphous silicon in certain instances, but may also be of or include hydrogenated amorphous silicon carbon or hydrogenated amorphous silicon germanium, or the like, in certain example embodiments of this invention. For example and without limitation, when a photon of light is absorbed in the i-layer it gives rise to a unit of electrical current (an electron-hole pair). The p and n-layers, which contain charged dopant ions, set up an electric field across the i-layer which draws the electric charge out of the i-layer and sends it to an optional external circuit where it can provide power for electrical components. It is noted that while certain example embodiments of this invention are directed toward amorphous-silicon based photovoltaic devices, this invention is not so limited and may be used in conjunction with other types of photovoltaic devices in certain instances including but not limited to devices including other types of semiconductor material, tandem thin-film solar cells, and the like. Certain example embodiments of this invention may be applicable to CdS/CdTe type photovoltaic devices, for instance.

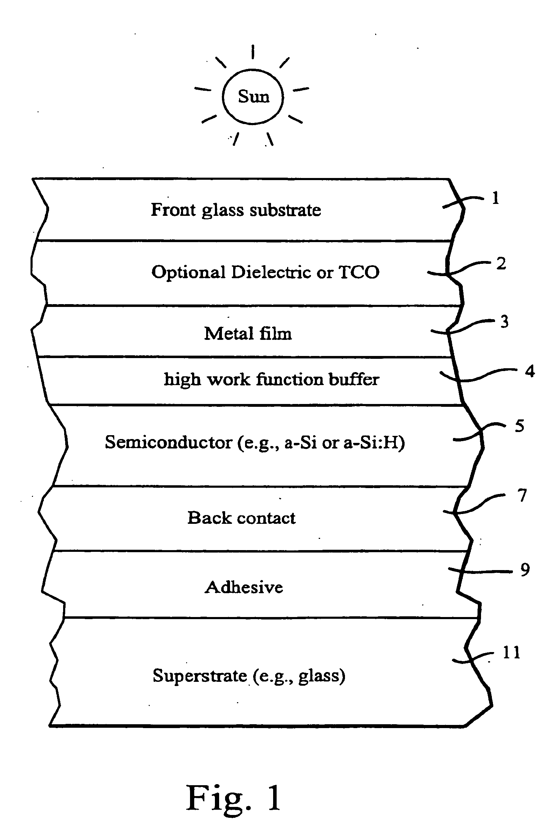

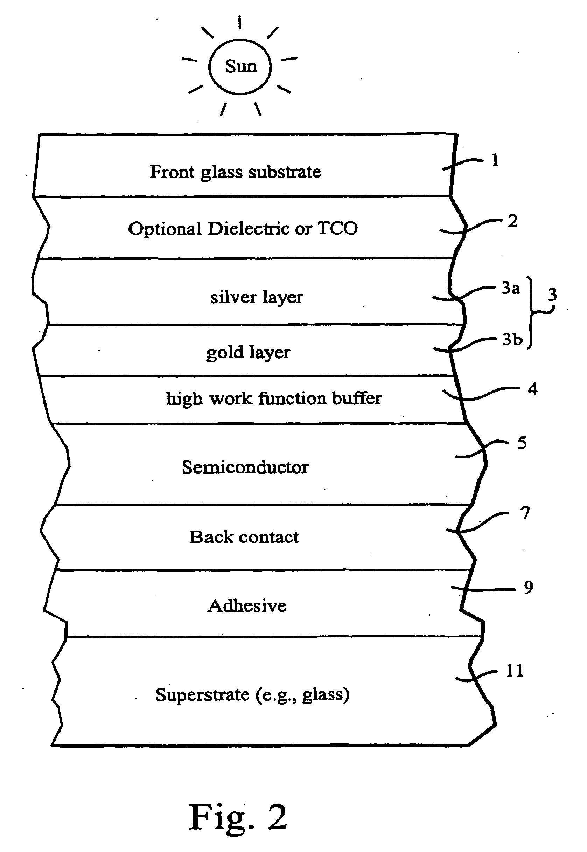

Fig. 1 is a cross sectional view of a photovoltaic device according to an example embodiment of this invention. The photovoltaic device includes transparent front glass substrate 1, optional dielectric or transparent conductive oxide (TCO) nucleation layer 2, single or multi-layer metal film 3 optionally characterized by a relatively low work function, high work function buffer layer 4, active semiconductor film 5 of one or more semiconductor layers, back electrode or contact 7 which may be of a TCO or a metal, an optional encapsulant 9 or adhesive of a material such as ethyl vinyl acetate (EVA) or the like, and an optional superstrate 11 of a material such as glass. The front electrode in the Fig. 1 embodiment may be of or include metal film, 3, and optionally may also include high work function barrier layer 4 and/or layer 2 if one or both of these layers 2, 4 is/are conductive. Of course, other layer(s) which are not shown may also be provided in the device. Fig. 2 is similar to Fig. 1, except that the metal film 3 in the Fig. 2 embodiment includes first metal layer 3a of silver or the like and second metal layer 3b of gold or the like. The work function of the metal film 3 may vary depending upon which metal is used to make the same. For instance, while the work function of the metal film 3 is lower than that of the buffer film, the work function of the metal film may be said by some to be high when Ag, Au and/or Pd is used for the same since some consider these relatively high work function metals..

Front glass substrate 1 and/or rear superstrate (substrate) 11 may be made of soda-lime-silica based glass in certain example embodiments of this invention. While substrates 1, 11 may be of glass in certain example embodiments of this invention, other materials such as quartz or the like may instead be used as substrate(s) 1 and/or 11. Moreover, superstrate 11 is optional in certain instances. Glass 1 and/or 11 may or may not be thermally tempered and/or patterned in certain example embodiments of this invention. Additionally, it will be appreciated that the word "on" as used herein covers both a layer being directly on and indirectly on something, with other layers possibly being located therebetween.

Nucleation layer 2 may be provided between the front glass substrate 1 and the metal film 3 in certain example embodiments of this invention. The nucleation layer 2 may be used to improve the quality of the metal film 3 and/or to improve adhesion of the metal film 3 to the glass substrate 1. In certain example embodiments, the nucleation layer 2 may be a TCO of or including a material such as tin oxide, fluorine-doped tin oxide, zinc oxide, aluminum-doped zinc oxide, indium zinc oxide, indium tin oxide, or the like. Alternatively, the nucleation layer 2 may be a dielectric in certain example embodiments of this invention such as zinc oxide, tin oxide, or the like. In certain example embodiments of this invention, nucleation layer 2 is from about 40 to 4,000 Å thick, more preferably from about 60 to 1,000 Å thick, even more preferably from about 80 to 400 Å thick, with an example being about 50 or 100 Å (i.e., about 5 or 10 nm) thick. The nucleation layer 2 may have a relatively low work function in certain example embodiments of this invention. Again, metal film 3 may be said to be a low work function film in certain example embodiments.

In certain examples, metal film 3 may be of a single substantially metallic layer, or alternatively may be of a plurality of substantially metallic metal layers. While the metal film 3 is entirely metallic in certain example embodiments, it may also include small amounts of other element(s) such as oxygen or the like in certain instances. In certain example embodiments, each layer of conductive metal film 3 may be of or include Cu, Ag, Au, Ni, Pd, Al, alloys thereof, a combination of one or more of these metals with other metal(s), or the like. The use of copper for film 3 may be advantageous in certain example instances with respect to cost, transmission in the visible range, and work function (about 4.7 eV). For example, in one example, the metal film 3 may be made up of a single metal layer of or including Cu, Ag, Au, Ni, Pd, Al, or alloys of one or more of these metals. In another example embodiment shown in Fig. 2, the metal film 3 may be made up of or include a silver layer 3a and a gold layer 3b which are in contact with one another. Thus, it will be appreciated that in certain examples, the metal film 3 may be a multi-layer stack of dissimilar metals or metal alloys, or metal oxides, or a metal alloy with a graded composition. The metal film 3 is substantially or entirely metallic in certain example embodiments, and typically has a relatively low work function in certain example embodiments of this invention. In certain example embodiments of this invention, metal film 3 has a thickness of from about 20 to 600 Å, more preferably from about 40 to 200 Å, even more preferably of from about 60 to - 200 Å, with an example thickness being from about 90-150 Å.

High work function buffer layer or film 4 is provided between, and optionally contacting, the metal film 3 and the semiconductor 5 of the photovoltaic device. In certain example embodiments, the high work function buffer layer or film 4 may be made of a transparent conductive oxide (TCO) layer of or including indium tin oxide (oxygen-rich ITO, or stoichiometric ITO), indium zinc oxide, zinc oxide, zinc aluminum oxide, tin oxide which may or may not be doped with fluorine, tin antimony oxide, or the like. For example, in certain example embodiments of this invention, high work function buffer film 4 may be formed by sputtering a ceramic ITO target in a gaseous atmosphere including a mixture of Ar (and/or any other inert gas) and oxygen gases; in other example embodiments film 4 may be formed by sputtering a metal InSn target in a gaseous atmosphere including a mixture of Ar (and/or any other inert gas) and oxygen gases, with a high amount of oxygen gas being used to cause the resulting ITO film to be oxygen rich and have a higher work function. In other example embodiments of this invention, the high work function buffer layer or film 4 may be a dielectric of a material such as tin oxide, zinc oxide, or the like. In certain example embodiments of this invention, high work function buffer layer or film 4 has a thickness of from about 10 to 1,000 Å, more preferably from ' about 20 to 100 Å, even more preferably of from about 25 to 60 Å, with an example thickness being from about 30-50 Å. If film 4 is too thick, its work function may be undesirable. While the above thicknesses for layer or film 4 are particularly applicable when the high work function buffer layer or film 4 is a TCO, it is possible to make the high work function buffer layer 4 even thinner (e.g., about 5-30 Å thick, e.g., about 10 Å thick) when the layer or film 4 is a dielectric.

It will be appreciated that elements/films 1, 2, 3 and 4 are all substantially transparent in certain example embodiments of this invention, so that light can reach the active semiconductor/absorber of the photovoltaic device.

In certain example embodiments of this invention, the photovoltaic device may be made by providing glass substrate 1, and then depositing (e.g., via sputtering, pyrolysis, or any other suitable technique) layers 2, 3 and 4 on the substrate 1 in this order. Thereafter the structure including substrate 1 and the front electrode is coupled with the rest of the device in order to form the photovoltaic device shown in Fig. 1 (or Fig. 2). For example, the semiconductor layer 5 may then be formed over the front electrode structure on substrate 1, or alternatively may be formed on the other substrate 11 with the front contact structure thereafter being coupled to the same. Front electrode layers 3 (and optionally 4 and/or 2) are typically continuously, or substantially continuously, provided over substantially the entire surface of the semiconductor film 5 in certain example embodiments of this invention, although it is possible that the front electrode layers may be patterned (e.g., via using laser etching or the like) into different shapes in certain instances.

In photovoltaic devices or the like, good electrical conductivity in the normal direction is desired in addition to conductivity in the lateral direction, in order to effectively extract generated charge carriers from the semiconductor device. Good conductivity is provided via at least the metal film 3. A potential problem in this regard is a considerable energetic difference between the work function of the metal film 3 and the Fermi level of the semiconductor absorber 5. For example and without limitation, in the case of amorphous silicon (a-Si) or micromorph silicon solar cells, where the front absorber is a-Si or a-Si:H, the difference between the work function of a metal film 3 (Ag for instance) and the Fermi level of the absorber 5 can be 0.9 eV which can significantly lower the device's efficiency. In order to overcome this potential problem, according to certain example embodiments of this invention, there is used a combination of a thin metal film 3 and a thin work-function matching buffer film 4 for use in connection with the front electrode structure. The work function matching buffer film 4 is provided for work function substantially matching of the metal film 3 and the semiconductor absorber 5 of the photovoltaic device. This causes the semiconductor absorber 5 to release generated holes much easier; in other words, its Fermi level can be raised and the potential barrier for the charge carriers can be reduced thereby improving efficiency of the device. In certain example embodiments of this invention, the high work function buffer 4 may be made of oxygen-rich ITO or any other suitable material as discussed herein, in certain example instances. The high-work function buffer film 4 is located between the low work-function metal film 3 and the uppermost semiconductor portion (e.g., p-type semiconductor portion) of film 5 of the photovoltaic device so as to provide for substantial work-function matching between the low work-function metal film 3 and the high work-function uppermost semiconductor portion of the device, so as to reduce a potential barrier for holes extracted from the device by the front electrode.

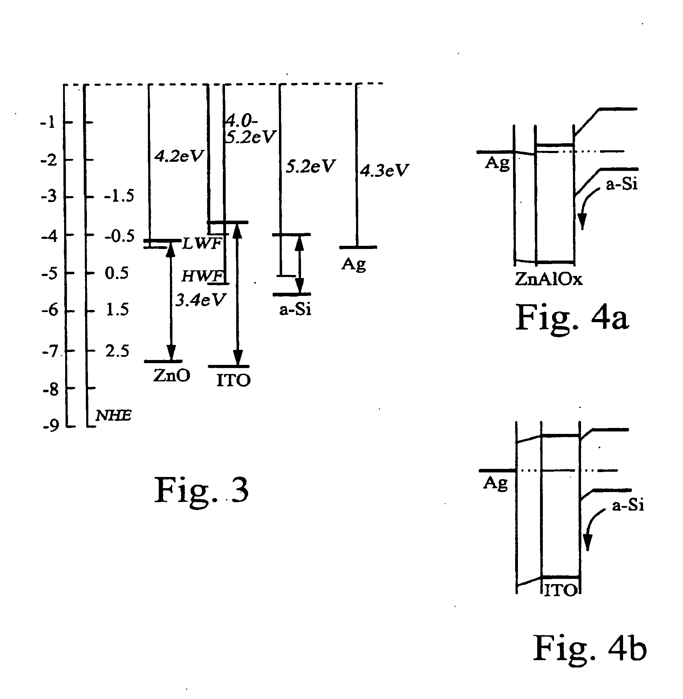

The buffer film 4 for substantial work function matching may be a semiconductor such as a TCO (e.g., ITO, other material mentioned herein, or any other suitable material) having a large energy of the Fermi level, although it is possible that a very thin dielectric could also be used for this film/layer. Fig. 3 illustrates the general concept and Figs. 4a-4b demonstrate the advantage of ITO over other buffer materials such as ZnAlOx from the point of view of work function matching of the metal film 3 and the semiconductor 5. The use of an ultra-thin dielectric as film 4 is based on its tunneling properties, when the phrase effective work function can be applied; this means that when films 3 and 5 are separated by an ultra-thin dielectric (e.g., one type of film 4), the semiconductor absorber 5 will can release the generated holes much easier. In other terms, its Fermi level is raised and the potential barrier for the charge carriers can be reduced thereby improving efficiency of the device. In certain example embodiments, the work function of the metal film 3 is substantially matched with the Fermi level of the absorber 5 by tuning the Fermi level adjustment of the buffer film 4; this may be achieved for example by varying the deposition parameters of the film 4. Thus, it will be appreciated that the work function of the buffer or work function matching film 4 is adjusted through deposition conditions to be greater than the work function of the metal film 3 and/or smaller than the Fermi level of the uppermost layer or layer portion of the semiconductor absorber film 5.

The use of the matching film 4, such as ITO or a thin dielectric, can also provide improved durability of the layer stack so that the coating can be in-line deposited and also shipped efficiently to solar cell manufacturers. In other words, film 4 can also be considered a protective capping layer for the metal film 3 so as to protect the same during shipment or the like.

In certain example embodiments of this invention, the high work-function and/or work function matching film 4 has a work-function of from about 4.0 to 5.7 eV (e.g., for amorphous silicon or micromorph solar cells, for example but without limitation), more preferably from about 4.3 to 5.2 eV, even more preferably from about 4.5-5.0 eV, still more preferably from about 4.6 to 4.8 eV, with an example being about 4.7 eV. In certain example embodiments, the high work function buffer film 4 has a work function of at least about 4% higher than that of the metal film 3, more preferably at least 6% higher, and most preferably at least about 10% higher than the work function of the metal film 3.

In certain example embodiments of this invention, the overall front electrode, including at least metal film 3, may have a sheet resistance (Rₛ) of from about 2-50 ohms/square, more preferably from about 2-15 ohms/square, and most preferably from about 2-10 ohms/square.

the active semiconductor region or film 5 may include one or more layers, and may be of any suitable material. For example, the active semiconductor film 5 of one type of single junction amorphous silicon (a-Si) photovoltaic device includes three semiconductor layers, namely a p-layer, an n-layer and an i-layer. The p-type a-Si layer of the semiconductor film 5 may be the uppermost portion of the semiconductor film 5 in certain example embodiments of this invention; and the i-layer is typically located between the p and n-type layers. These amorphous silicon based layers of film 5 may be of hydrogenated amorphous silicon in certain instances, but may also be of or include hydrogenated amorphous silicon carbon or hydrogenated amorphous silicon germanium, or other suitable material(s) in certain example embodiments of this invention. It is possible for the active region 5 to be of a double-junction type in alternative embodiments of this invention. CdS/CdTe may also be used for semiconductor 5 in certain example instances.

Back contact or electrode 7 may be of any suitable electrically -conductive material. For example and without limitation, the back contact or electrode 7 may be of a TCO and/or a metal in certain instances. Example TCO materials for use as back contact or electrode 7 include indium zinc oxide, indium-tin-oxide (ITO), tin oxide, and/or zinc oxide which may be doped with aluminum (which may or may not be doped with silver). The TCO of the back contact 7 may be of the single layer type or a multi-layer type in different instances. Moreover, the back contact 7 may include both a TCO portion and a metal portion in certain instances. For example, in an example multi-layer embodiment, the TCO portion of the back contact 7 may include a layer of a material such as indium zinc oxide (which may or may not be doped with silver), indium-tin-oxide (ITO), tin oxide, and/or zinc oxide closest to the active region 5, and the back contact may include another conductive and possibly reflective layer of a material such as silver, molybdenum, platinum, steel, iron, niobium, titanium, chromium, bismuth, antimony, or aluminum further from the active region 5 and closer to the superstrate 11. The metal portion may be closer to superstrate 11 compared to the TCO portion of the back contact 7.

The photovoltaic module may be encapsulated or partially covered with an encapsulating material such as encapsulant 9 in certain example embodiments. An example encapsulant or adhesive for layer 9 is EVA. However, other materials such as Tedlar type plastic, Nuvasil type plastic, Tefzel type plastic or the like may instead be used for layer 9 in different instances.

TCO materials typically used as front electrodes/contacts in thin-film photovoltaic devices (e.g., solar cells) are often n-type, and thus create a Schottky barrier at the interface between the TCO and the uppermost semiconductor portion of the device which may be a p-type a-Si:H portion/layer (such a Schottky barrier may be in a reverse direction to the built-in field). This barrier is problematic in that it can form a barrier for holes extracted from the cell by the front contact thereby leading to inefficient performance of the device. In order to overcome this problem, a material with a higher work function is used. In certain embodiments of this invention, multi-layer front electrode structure is provided by forming a metal film 3 and additionally a thin buffer film 4 to provide for approximate or more substantial work-function matching between the film 3 and the uppermost portion of semiconductor film 5. In certain example embodiments, the oxygen level may gradually or periodically increase from the interface between layers 3 and 4 to the interface between layers/films 4 and 5. In other words, the high work function film/layer 4 may be oxidation graded in certain example non-limiting embodiments so as to have a higher oxygen content in a portion thereof immediately adjacent semiconductor film 5 than at a portion thereof adjacent metal film 3; this may help improve performance for the reasons discussed herein.

## Claims

1. A photovoltaic device comprising:
a front glass substrate (1),
an active semiconductor film (5),
an electrically conductive and substantially transparent front electrode structure located between at least the front glass substrate (1) and the semiconductor film (5), wherein the front electrode structure comprises a substantially transparent metal film (3), and
a high work function buffer film (4),wherein the high work function buffer film (4) has a work-function that is higher than a work-function of the metal film (3), and wherein the high work function buffer film (4) is located between the metal film (3) and an uppermost portion of the semiconductor film (5),
**characterized in that**
the substantially transparent metal film (3) comprises first (3a) and second (3b) substantially metallic layers made of different metals.

2. The photovoltaic device of claim 1, wherein the high work function buffer film (4) comprises one of: a TCO film, indium tin oxide or oxygen-rich indium-tin-oxide (ITO).

3. The photovoltaic device of claim 1, wherein the metal film (3) has a work-function of no greater than about 4.2 eV, and the high work function buffer film (4) has a work function of at least 4.3 eV.

4. The photovoltaic device of claim 1, wherein the high work function buffer film (4) has a work function of at least about 4% higher than that of the metal film (3), more preferably at least 6% higher, and most preferably at least about 10% higher.

5. The photovoltaic device of claim 1, wherein the high work function buffer film (4) has a work-function of from about 4.0 to 5.7 eV, preferably of from about 4.3 to 5.2 eV, and most preferably from about 4.5 to 5.0 eV.

6. The photovoltaic device of claim 1, wherein the metal film (3) is from about 2-60 µm (20-600 angstroms) thick, and the high work function buffer film (4) is from about 1-100nm (10 to 1,000 angstroms) thick, and preferably wherein the metal film (3) is from about 4-20nm (40-200 angstroms) thick, and the high work function buffer film (4) is from about 1-10nm (10 to 100 angstroms) thick.

7. The photovoltaic device of claim 1, wherein the high work function buffer film (4) is a dielectric and has a thickness of from about 05-3nm (5-30 angstroms).

8. An electrode structure adapted for use in a photovoltaic device, the electrode structure comprising:
a glass substrate (1),
a substantially transparent metal film (3) supported by the glass substrate (1),
a high work function buffer film (4) supported by the glass substrate (1), wherein the high work function buffer film (4) has a work-function that is higher than a work-function of the metal film (3), and the metal film (3) is located between at least the high work function buffer film (4) and the glass substrate (1),
**characterized in that**
the metal film (3) comprises first and second different substantially metallic layers.

9. The electrode structure of claim 8, wherein the high work function buffer film (4) comprises a TCO film.

10. The electrode structure of claim 8, wherein the high work function buffer film (4) directly contacts the metal film (3) and is also adapted to directly contact a semiconductor film (5) of the photovoltaic device.

11. The electrode structure of claim 8, wherein the metal film (3) has a work function of no greater than about 4.2 eV, and the high work function buffer film (4) has a work function of at least 4.3 eV, and wherein the high work function buffer film has a work function of at least about 4% higher than that of the metal film.

12. The electrode structure of claim 8, wherein the metal film (3) is from about 4-20nm (40-200 angstroms) thick, and the high work function buffer film (4) is from about 1-10nm (10 to 100 angstroms) thick.

## Patentansprüche

1. Ein photovoltaisches Gerät, umfassend:
ein vorderes Glassubstrat (1),
eine aktive Halbleiterschicht (5),
eine elektrisch leitfähige und im Wesentlichen transparente vordere Elektrodenstruktur, die zwischen zumindest dem vorderen Glassubstrat (1) und der Halbleiterschicht (5) angeordnet ist, wobei die vordere Elektrodenstruktur eine im Wesentlichen transparente Metallschicht (3) umfasst, und
eine Pufferschicht (4) hoher Austrittsarbeit (*high work-function buffer film*), wobei die Pufferschicht (4) hoher Austrittsarbeit eine Austrittsarbeit hat, die höher ist als eine Austrittsarbeit der Metallschicht (3), und wobei die Pufferschicht (4) hoher Austrittsarbeit zwischen der Metallschicht (3) und einem obersten Abschnitt der Halbleiterschicht (5) angeordnet ist,
**dadurch gekennzeichnet, dass**
die im Wesentlichen transparente Metallschicht erste (3a) und zweite (3b) im Wesentlichen metallische Schichten, die aus unterschiedlichen Metallen gemacht sind, umfasst.

2. Das photovoltaische Gerät nach Anspruch 1, wobei die Pufferschicht (4) hoher Austrittsarbeit eines der folgenden umfasst: eine transparente, leitende Oxidschicht (TCO); Indium-Zinn-Oxid oder sauerstoffreiches Indium-Zinn-Oxid (ITO).

3. Das photovoltaische Gerät nach Anspruch 1, wobei die Metallschicht (3) eine Austrittsarbeit von nicht mehr als etwa 4,2 eV hat, und die Pufferschicht (4) hoher Austrittsarbeit eine Austrittsarbeit von zumindest 4,3 eV hat.

4. Das photovoltaische Gerät nach Anspruch 1, wobei die Pufferschicht (4) hoher Austrittsarbeit eine Austrittsarbeit hat, die zumindest etwa 4 % höher ist als die der Metallschicht (3), mehr bevorzugt zumindest 6 % höher ist, und am meisten bevorzugt zumindest etwa 10 % höher ist.

5. Das photovoltaische Gerät nach Anspruch 1, wobei die Pufferschicht (4) hoher Austrittsarbeit eine Austrittsarbeit von etwa 4,0 - 5,7 eV hat, vorzugsweise von etwa 4,3 - 5,2 eV und am meisten bevorzugt von etwa 4,5 - 5,0 eV hat.

6. Das photovoltaische Gerät nach Anspruch 1, wobei die Metallschicht (3) von etwa 2 - 60 nm (20 - 600 Ä) dick ist und die Pufferschicht (4) hoher Austrittsarbeit von etwa 1 - 100 nm (10 - 1000 Ä) dick ist, und wobei vorzugsweise die Metallschicht (3) von etwa 4 - 20 nm (40 - 200 Å) dick ist, und die Pufferschicht (4) hoher Austrittsenergie von etwa 1 - 10 nm (10 - 100 Å) dick ist.

7. Das photovoltaische Gerät nach Anspruch 1, wobei die Pufferschicht (4) hoher Austrittsarbeit dieelektrisch ist und eine Dicke von etwa 0,5 - 3 nm (5 - 30 Ä) hat.

8. Eine Elektrodenstruktur, die eingerichtet ist, um in einem photovoltaischen Gerät verwendet zu werden, welche Elektrodenstruktur aufweist:
ein Glassubstrat (1),
eine im Wesentlichen transparente metallische Schicht (3), die von dem Glassubstrat (1) getragen ist,
eine Pufferschicht (4) hoher Austrittsarbeit, die von dem Glassubtrat (1) getragen ist, wobei die Pufferschicht (4) hoher Austrittsarbeit eine Austrittsarbeit hat, die höher ist als eine Austrittsarbeit der Metallschicht (3), und wobei die Metallschicht (3) zwischen zumindest der Pufferschicht (4) hoher Austrittsarbeit und dem Glassubstrat (1) angeordnet ist,
**dadurch gekennzeichnet, dass**
die Metallschicht (3) unterschiedliche erste und zweite im Wesentlichen metallische Schichten umfasst.

9. Die Elektrodenstruktur nach Anspruch 8, wobei die Pufferschicht (4) hoher Austrittsarbeit eine transparente leitfähige Oxidschicht (TCO) umfasst.

10. Die Elektrodenstruktur nach Anspruch 8, wobei die Pufferschicht (4) hoher Austrittsarbeit direkt die Metallschicht (3) kontaktiert und außerdem eingerichtet ist, um direkt eine Halbleiterschicht (5) des photovoltaischen Geräts zu kontaktieren.

11. Die Elektrodenstruktur nach Anspruch 8, wobei die Metallschicht (3) eine Austrittsarbeit von nicht mehr als etwa 4,2 eV hat, und die Pufferschicht hoher Austrittsarbeit eine Austrittsarbeit von zumindest 4,3 eV hat, und wobei die Pufferschicht hoher Austrittsarbeit eine Austrittsarbeit hat, die zumindest etwa 4 % höher ist als die der Metallschicht.

12. Die Elektrodenstruktur nach Anspruch 8, wobei die Metallschicht (3) von etwa 4 - 20 nm (40 - 200 Å) dick ist, und die Pufferschicht (4) hoher Austrittsarbeit von etwa 1 - 10 nm (10 - 100 Å) dick ist.

## Revendications

1. Un dispositif photovoltaïque comprenant :
un substrat frontal en verre (1),
un film de semi-conducteur actif (5),
une structure d'électrode frontale électriquement conductrice et substantiellement transparente située entre au moins le substrat frontal en verre (1) et le film semi-conducteur (5), la structure d'électrode frontale comprenant un film métallique substantiellement transparent (3), et
un film tampon à travail de sortie élevé (4), le film tampon à travail de sortie élevé (4) présentant un travail de sortie qui est supérieur à un travail de sortie du film métallique (3), et le film tampon à travail de sortie élevé (4) étant situé entre le film métallique (3) et une partie la plus supérieure du film semi-conducteur (5),
**caractérisé en ce que**
le film métallique substantiellement transparent (3) comprend une première (3a) et une seconde (3b) couches substantiellement métalliques réalisées en métaux différents.

2. Le dispositif photovoltaïque de la revendication 1, dans lequel le film tampon à travail de sortie élevé (4) comprend l'un d'entre : un film de TCO, un oxyde indium-étain ou un oxyde indium-étain riche en oxygène (ITO).

3. Le dispositif photovoltaïque de la revendication 1, dans lequel le film métallique (3) présente un travail de sortie non supérieur à environ 4,2 eV, et le film tampon à travail de sortie élevé présente un travail de sortie d'au moins 4,3 eV.

4. Le dispositif photovoltaïque de la revendication 1, dans lequel le film tampon à travail de sortie élevé (4) présente un travail de sortie qui est au moins environ 4 % supérieur à celui du film métallique (3), de préférence au moins 6 % supérieur, et très préférentiellement au moins environ 10 % supérieur.

5. Le dispositif photovoltaïque de la revendication 1, dans lequel le film tampon à travail de sortie élevé (4) présente un travail de sortie compris entre environ 4,0 et 4,7 eV, de préférence entre 4,3 et 5,2 eV, et très préférentiellement entre environ 4,5 et 5,0 eV.

6. Le dispositif photovoltaïque de la revendication 1, dans lequel le film métallique (3) a une épaisseur d'environ 2 à 60 nm (20 à 600 angströms), et le film tampon à travail de sortie élevé (4) a une épaisseur d'environ 1 à 100 nm (10 à 1000 angströms), et de préférence dans lequel le film métallique (3) a une épaisseur comprise entre environ 4 et 20 nm (40 et 200 angströms), et le film tampon à travail de sortie élevé (4) a une épaisseur comprise entre environ 1 et 10 nm (10 et 100 angströms).

7. Le dispositif photovoltaïque de la revendication 1, dans lequel le film tampon à travail de sortie élevé (4) est un diélectrique et présente une épaisseur comprise entre environ 0,5 et 3 nm (5 et 30 angströms).

8. Une structure d'électrode apte à une utilisation dans un dispositif photovoltaïque, la structure d'électrode comprenant :
un substrat en verre(1),
un film métallique substantiellement transparent (3) supporté par le substrat en verre (1),
un film tampon à travail de sortie élevé (4) supporté par le substrat en verre,
le film tampon à travail de sortie élevé (4) présentant un travail de sortie qui est supérieur à un travail de sortie du film métallique (3), et le film métallique (3) étant situé entre au moins le film tampon à travail de sortie élevé (4) et le substrat en verre (1),
**caractérisé en ce que**
le film métallique (3) comprend une première et une seconde couches différentes substantiellement métalliques.

9. La structure d'électrode de la revendication 8, dans laquelle le film tampon à travail de sortie élevé (4) comprend un film de TCO.

10. La structure d'électrode de la revendication 8, dans laquelle le film tampon à travail de sortie élevé (4) vient directement en contact avec le film métallique (3) et est également apte à venir directement en contact avec un film semi-conducteur (5) du dispositif photovoltaïque.

11. La structure d'électrode de la revendication 8, dans laquelle le film métallique (3) présente un travail de sortie non supérieur à environ 4,2 eV, et le film tampon à travail de sortie élevé (4) présente un travail de sortie d'au moins 4,3 eV, et dans laquelle le film tampon à travail de sortie élevé présente un travail de sortie au moins environ 4 % supérieur à celui du film métallique.

12. La structure d'électrode de la revendication 8, dans laquelle le film métallique (3) a une épaisseur comprise entre environ 4 et 20 nm (40 et 200 angströms), et le film tampon à travail de sortie élevé (4) a une épaisseur comprise entre environ 1 et 10 nm (10 et 100 angströms).
